Europäisches Patentamt

European Patent Office

Office européen des brevets

(11) Publication number: **0 341 458**
**A1**

## EUROPEAN PATENT APPLICATION

(21) Application number: **89106941.1**

(22) Date of filing: **18.04.89**

(51) Int. Cl.⁴: **H05K 1/18 , H05K 3/34**

(30) Priority: **13.05.88 JP 116081/88**
**16.05.88 JP 118989/88**
**04.10.88 JP 251551/88**
**17.02.89 JP 37739/89**

(43) Date of publication of application:
**15.11.89 Bulletin 89/46**

(84) Designated Contracting States:
**DE FR GB**

(71) Applicant: **PIONEER ELECTRONIC
CORPORATION
No. 4-1, Meguro 1-chome
Meguro-ku Tokyo 153(JP)**

(72) Inventor: **Ishii, Satoshi c/o Pioneer
Tokorozawa Plant
2610, Hanazono 4-chome
Tokorozawa-City Saitama(JP)**

(74) Representative: **Klingseisen, Franz, Dipl.-Ing.
et al
Dr. F. Zumstein Dipl.-Ing. F. Klingseisen
Bräuhausstrasse 4
D-8000 München 2(DE)**

(54) **Double-sided board circuit.**

(57) A double-sided board circuit includes a board (11) having insertion holes (12), a pair of electrically conductive patterns (15) disposed on the face and back of the board (11), and an electronic component (13) having directly connected electrically conductive wires (13a) inserted respectively through the insertion holes (12), at least one of the conductive wires being soldered at two positions to the conductive patterns (15) on the face and back of the board (11) to electrically connect the conductive patterns (15).

Fig. 2

## DOUBLE-SIDED BOARD CIRCUIT

### BACKGROUND OF THE INVENTION

1. Field of the Invention:

The present invention relates to a double-sided board circuit having electrically conductive patterns on respective opposite surfaces of a circuit board, the conductive patterns being electrically connected by lead wires rather than through hole soldering.

2. Description of the Prior Art:

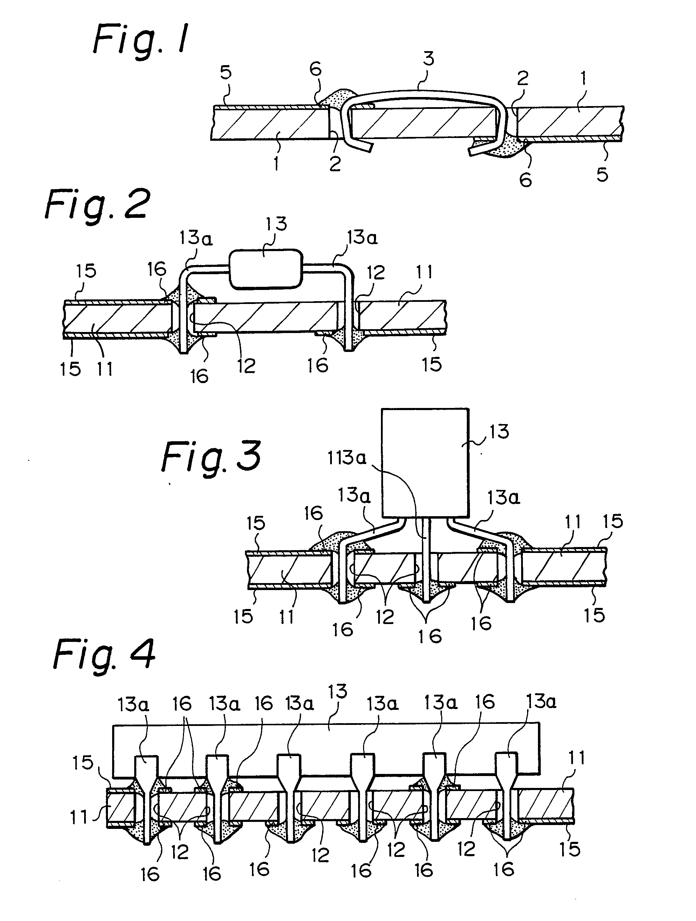

There are known double-sided boards or printed circuits with electrically conductive patterns on their opposite surfaces. Heretofore, the conductive patterns on the opposite sides of a double-sided board may be electrically connected by different methods. According to one known connecting arrangement, a through hole is defined in the board, and the conductive patterns are electrically connected by a metal layer plated in the through hole. FIG. 1 of the accompanying drawings shows another connecting scheme in which the ends of a jumper wire 3 are inserted into through holes 2 defined in a board 1 from one surface thereof, and the jumper wire 3 is soldered to lands 6, positioned on the edges of the holes 2, of electrically conductive patterns 5 on the opposite sides of the board 1, thus electrically connecting the conductive patterns 5 to each other.

The former electrical connection is disadvantageous in that a complex plating process is required to plate the through hole and it is difficult to reduce the cost of the double-sided board. Where the jumper wire is employed to interconnect the conductive patterns, the efficiency of utilization of the board area is reduced by the through holes and the lands which are used only for connecting the conductive patterns. The efficiency of assembling the double-sided board is also low since the jumper cable has to be inserted into the through holes and soldered to the conductive patterns only for connecting the conductive patterns.

### SUMMARY OF THE INVENTION

In view of the aforesaid drawbacks of the conventional double-sided boards, it is an object of the present invention to provide a double-sided board circuit having electrically conductive patterns on the opposite sides of a board, the conductive patterns being electrically connected to each other at a low cost and with high assembling efficiency while allowing high efficiency of utilization of a board area.

According to a first feature of the present invention, there is provided a double-sided board circuit comprising: a board having insertion holes; a pair of electrically conductive patterns disposed on the face and back of said board; and an electronic component having directly connected electrically conductive wires inserted respectively through said insertion holes, at least one of said conductive wires being soldered at two positions to said conductive patterns on the face and back of said board.

According to a second feature of the present invention, there is provided a double-sided board circuit comprising: a board having groups of insertion holes; a pair of electrically conductive patterns disposed on the face and back of said board and including lands disposed around peripheral edges of said insertion holes; and components having filamentary terminals inserted through said groups of insertion holes and soldered to said lands; the lands disposed around at least one of said insertion holes being disposed respectively on the face and back of said board, the other lands being disposed on at least one of the face and back of said board, the filamentary terminal which is inserted through said one of the insertion holes being soldered to the lands on the face and back of the board.

According to a third feature of the present invention, there is provided a double-sided board circuit comprising: a board having groups of insertion holes; a pair of electrically conductive patterns disposed on the face and back of said board and including lands disposed around peripheral edges of said insertion holes; and components having filamentary terminals inserted through said groups of insertion holes and soldered to said lands; the lands disposed around at least one of said insertion holes being disposed respectively on the face and back of said board, the filamentary terminal which is inserted through said one of the insertion holes being soldered to the lands on the face and back of the board, at least one of said lands disposed around said one of the insertion holes on the face and back of the board extending only at a portion of the peripheral edge of said one of the insertion holes, thus preventing said one of the insertion holes from being closed off by solder bodies.

According to a fourth feature of the present invention, there is provided a double-sided board circuit comprising: a board; a pair of electrically conductive patterns disposed on the face and back of said board, at least one of said conductive patterns including mounting lands, the other conductive pattern including short-circuiting lands; a surface-mounted component mounted said mounting lands and having electrically conductive ends soldered to said mounting lands; said board having through holes defined therein and extending between the face and back of the board, said through holes being free of plated layers; and electrically conductive wires inserted through said through holes and soldered to said short-circuiting lands and said conductive ends, respectively.

The above and other objects, features and advantages of the present invention will become more apparent from the following description when taken in conjunction with the accompanying drawings in which preferred embodi ments of the present invention are shown by way of illustrative example.

## BRIEF DESCRIPTION OF THE DRAWINGS

FIG. 1 is a fragmentary vertical cross-sectional view of a conventional double-sided board circuit;

FIGS. 2 through 4 are fragmentary cross-sectional views of double-sided board circuits according to a first embodiment of the present invention;

FIGS. 5(a) through 5(f) are cross-sectional views showing a process of manufacturing the double-sided board circuit shown in FIG. 2;

FIGS. 6(a) through 6(c) are fragmentary plan, vertical cross-sectional, and bottom views of a double-sided board circuit according to a second embodiment of the present invention;

FIG. 7 is a fragmentary vertical cross-sectional view illustrating a process of manufacturing the double-sided board circuit of FIGS. 6(a) through 6(c);

FIGS. 8 through 11 are fragmentary bottom views showing modifications of the double-sided board circuit shown in FIGS. 6(a) through 6(c);

FIGS. 12(a) and 12(b) are fragmentary vertical cross-sectional and bottom views of a double-sided board circuit according to a third embodiment of the present invention;

FIGS. 13(a) through 13(c) and 14 through 16 are views showing how a pinhole or blowhole is formed in a double-sided board circuit different from that of the present invention;

FIGS. 17(a) through 17(c) are fragmentary plan, vertical cross-sectional, and bottom views of a double-sided board circuit according to a fourth embodiment of the present invention;

FIGS. 18 through 20 are fragmentary bottom views showing modifications of the double-sided board circuit shown in FIGS. 17(a) through 17(c);

FIGS. 21(a) through 21(c) are fragmentary plan, vertical cross-sectional, and bottom views of a double-sided board circuit according to a fifth embodiment of the present invention;

FIG. 22 is a fragmentary bottom view showing a modification of the double-sided board circuit illustrated in FIGS. 21(a) through 21(c);

FIGS. 23(a) through 23(c) are fragmentary plan, vertical cross-sectional, and bottom views of a double-sided board circuit according to a sixth embodiment of the present invention;

FIGS. 24(a) through 24(c) and 25 through 29 are fragmentary bottom views showing modifications of the double-sided board circuit shown in FIGS. 23(a) through 23(c);

FIGS. 30(a) through 30(c) are fragmentary plan, vertical cross-sectional, and bottom views of a double-sided board circuit according to a seventh embodiment of the present invention;

FIGS. 31 through 33 are fragmentary bottom views showing modifications of the double-sided board circuit shown in FIGS. 30(a) through 30(c); and

FIGS. 34 and 35 are fragmentary vertical cross-sectional views of a double-sided board circuit according to an eighth embodiment of the present invention.

## DETAILED DESCRIPTION OF THE PREFERRED EMBODIMENTS

FIGS. 2 through 4 fragmentarily illustrate double-sided board circuits according to a first embodiment of the present invention.

As shown in each of FIGS. 2 through 4, a circuit board 11 has insertion holes 12 defined therethrough and opening at the face and back thereof. The insertion holes 12 receive therein filamentary terminals 13a of an electronic component 13 mounted on the board 11. The insertion holes 12 are defined in a group dependent on the number of filamentary terminals 13a of the electronic component 13.

The electronic component 13 may be any of various electronic parts. For example, it may be an axial-lead component such as a resistor as shown in FIG. 2, or a radial-lead component such as a transistor as shown in FIG. 3, or a specially shaped component such as an IC chip as shown in FIG. 4.

The board 11 supports electrically conductive patterns 15 mounted on the face and back thereof. A land 16 is formed around the peripheral edge of each of the insertion holes 12 on at least one of the face and back of the board 11. Lands 16 are formed around the peripheral edge of at least one of the insertion holes 12 of the group corresponding to the electronic component 13, on both face and back of the board 11.

The filamentary terminals 13a of the electronic component 13 are inserted in the respective insertion holes 12, and soldered to the lands around the peripheral edges of the insertion holes 12. One of the filamentary terminals 13a which is inserted into the insertion hole 12 with the lands 16 formed around its peripheral edge on both face and back of the board 11 is soldered at two positions to the lands 16 on the face and back of the board 11.

The conductive patterns 15 on the face and back of the board 11 are thus electrically connected to each other by the soldered filamentary terminals 13a.

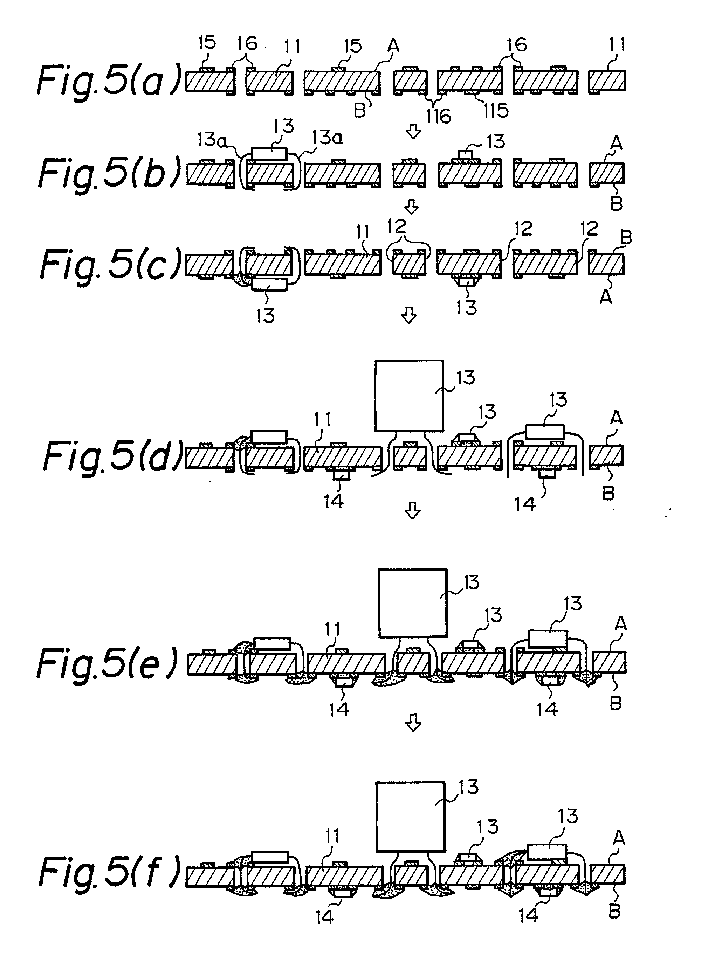

A process of manufacturing the double-sided board circuits shown in FIGS. 2 through 4 will be described with reference to FIGS. 5(a) through 5(f).

As illustrated in FIG. 5(a), a board 11 supports electrically conductive patterns 15 formed on the opposite surfaces thereof, and has insertion holes 12 defined therethrough. Then, filamentary terminals 13a of a heat-resistant electronic component 13 capable of withstanding the dip soldering process are automatically inserted into corresponding insertion holes 12, or the electronic element 13 is bonded to the surface A of the board 11 (FIG. 5(b)), after which the surface A is dipped for automatic dip soldering of the electronic component 13 (FIG. 5(c)). At this time, less heat-resistant electronic components which are to be mounted on the board 11 are not yet mounted on the board 11, leaving corresponding insertion holes 12 free of any filamentary terminals. Therefore, air can efficiently be discharged through those open insertion holes 12. One or more electronic component 14 of the so-called surface-mount type are attached to the surface B and, in some cases, the filamentary terminals of some less heat-resistant electronic components (not shown) are automatically or manually inserted into corresponding insertion holes 12 (FIG. 5(d)). Then, the surface B of the board 11 is dipped for automatic dip soldering (FIG. 5(e)). The filamentary terminals 13a of the less heat-resistant electronic components 13 are thereafter soldered for point-to-point wiring (FIG. 5(f)), thus completing a double-sided board circuit.

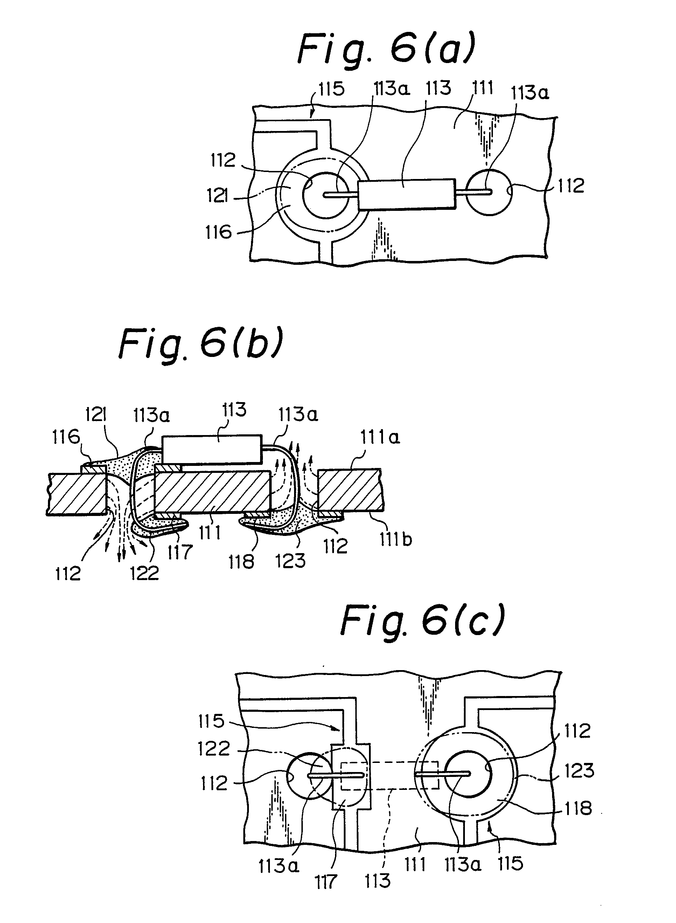

FIGS. 6(a) through 6(c) fragmentarily show a double-sided board circuit according to a second embodiment of the present invention. A double-sided board circuit has a circuit board 111 having insertion holes 112 defined therethrough and opening at the face and back thereof. The insertion holes 112 receive therein filamentary terminals 113a of an electronic component 113 mounted on the board 111. The insertion holes 112 are defined in a group dependent on the number of filamentary terminals 113a of the electronic component 113. The filamentary terminals 113a are bent over on the back of the board 111 to retain the electronic component 113 against removal from the board 111. In this embodiment, the filamentary terminals 113a are bent inwardly toward each other.

The electronic component 113 may be any of various electronic parts. For example, it may be an axial-lead component represented by a resistor, or a radial-lead component such as a transistor, or a specially shaped component such as an IC chip.

The board 11 supports electrically conductive patterns 115 in the form of copper foils, for example, mounted on the face and back thereof. Lands 116, 117, 118 are formed around the peripheral edges of the insertion holes 112 on at least one of the face and back of the board 111. Lands 116, 117 are formed around the peripheral edge of at least one of the insertion holes 112 of the group corresponding to the electronic component 113, on both face and back of the board 111.

The filamentary terminals 113a of the electronic component 113 are inserted in the respective insertion holes 112, and soldered to the lands 116, 117, 118 at the peripheral edges of the insertion holes 112 by solder bodies 121, 122, 123 applied by an automatic dip soldering device. One of the filamentary terminals 113a which is inserted into the insertion hole 112 with the lands 116, 117 formed around its peripheral edge on both face and back of the board 111 is soldered to the lands 116, 117 on the face and back of the board 11.

The conductive patterns 115 on the face and back of the board 111 are thus electrically connected to each other by the soldered filamentary terminals 113a. Since one of the filamentary terminals 113a is soldered to the lands 116, 117 on the face and back of the board 111, the load applied to the filamentary terminal 113a is divided into tensile and compressive loads imposed on the face and back of the board 111, so that the conductive patterns 115 are firmly joined to each other against easy peeling or removal from the board 111. Before the filamentary terminals 113a are soldered by the automatic dip soldering device, a flux is applied to the lands 116 through 118 for facilitating the soldering process.

As shown in FIGS. 6(b) and 6(c), at least one of the lands 116, 117, here the land 117, mounted respectively on the face and back of the board 111 around the peripheral edge of the insertion hole 112 is of a rectangular shape extending tangentially to, i.e., only partly in contact with or only at a portion of the peripheral edge of the insertion hole 112. With this arrangement, the opening of the insertion hole 112 at the back of the board 111 is not closed off by the solder body 122, but remains open at all times even after the filamentary terminal 113a has been soldered to that rectangular land 117. Consequently, a gas produced by the flux when the filamentary terminal 113a is soldered is not trapped in the insertion hole 112, and hence no pinhole or blowhole is formed in the fused solder bodies 121, 122.

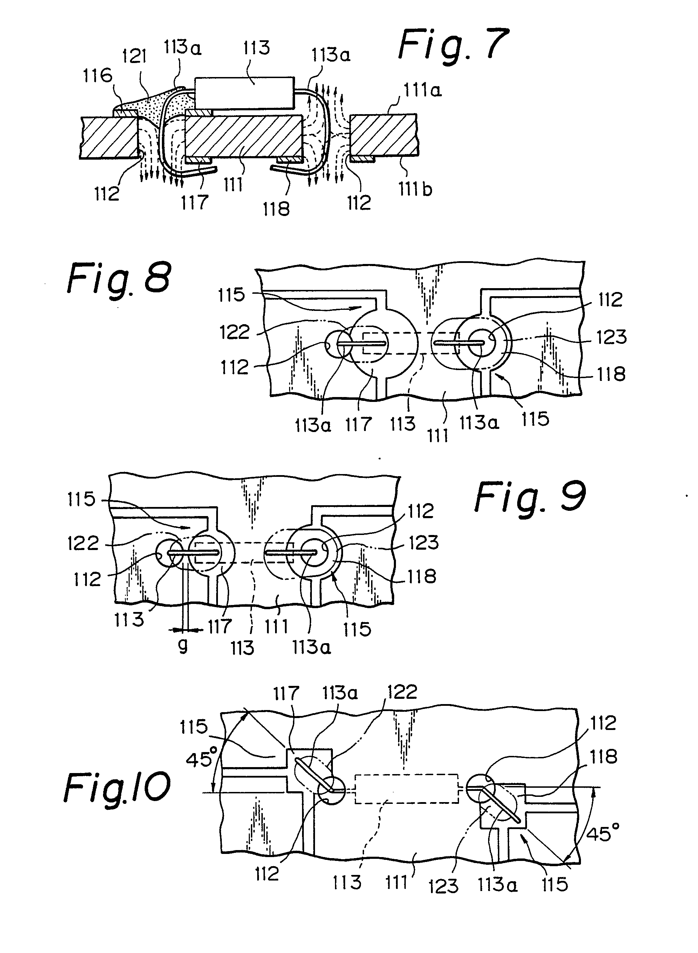

A process of producing the double-sided board circuit according to the second embodiment will be described below with reference to FIGS. 6(a) through 6(c) and 7.

As shown in FIGS. 6(a) and 7, a board 111 supports electrically conductive patterns 115 formed on the opposite surfaces thereof, and has insertion holes 112 defined therethrough. Then, filamentary terminals 113a of a heat-resistant electronic component 113 capable of withstanding the dip soldering process are automatically inserted into corresponding insertion holes 112 from the face 111a of the board 111, and the distal ends of the inserted filamentary terminals 113a are bent over on the back 111b of the board 111 by a clinching device. At this time, the electronic component 113 itself is bonded to the surface 111a of the board 111 by a heat-resistant adhesive. The board 111 is then dipped in the solder tank of an automatic dip soldering device to apply a solder body 121 to the surface 111a, as shown in FIGS. 6-(a) and 7, to connect the land 116 and the filamentary terminal 113a to each other. At this time, less heat-resistant electronic components to be installed on the surface 111a are not yet mounted. Therefore, the board 111 still has insertion holes 112 in which any filamentary terminals have not yet been inserted. Air can efficiently be discharged through those open insertion holes 112. Thereafter, the filamentary terminals 113a of the less heat-resistant electronic components 113 are automatically or manually inserted into corresponding insertion holes 112, and the electronic components 113 itself are bonded to the surface 111a of the board 111.

Then, the back 111b of the board 111 is dipped in the solder tank of the automatic dip soldering device to apply solder bodies 122, 123 to the back 111b, as shown in FIGS. 6(b) and 6(c). As can be seen from FIG. 6(b), at least one of the filamentary terminals 113a of the electronic component 113 is soldered to the lands 116, 117 on the face and back of the board 111. The conductive patterns on the face and back of the board 111 are now connected to each other. At least one of the lands 116, 117, here the land 117 on the back 111b, at one of the insertion holes 112 is not disposed fully around the peripheral edge of the insertion hole 112, but extends only tangentially to, i.e., only partly in contact with or only at a portion of the peripheral edge. Accordingly, the opening of the insertion hole 112 at the back of the board 111 is not closed off by the solder body 122. Therefore, as shown in FIG. 6(b), a gas produced by the flux when the filamentary terminal 113a is soldered can be discharged through the opening of the insertion hole 112.

After the above process, the filamentary terminals 113a of less heat-resistant electronic components 113 mounted on the surface 111a of the board 111 are soldered for point-to-point wiring, thus completing a double-sided board circuit.

FIGS. 8 through 11 show double-sided board circuits according to modifications of the present invention.

In the double-sided board circuit shown in FIGS. 6(a) through 6(c) and 7, the land 117 on the back 111b of the board 111 which is soldered to the filamentary terminal 113a in at least one of the insertion holes 112 is of a rectangular shape. According to each of modifications shown in FIGS. 8 and 9, such a land 117 is of a circular shape. In the modification of FIG. 8, the land 117 is held in contact with the insertion hole 112. However, the land 117 according to the modification of FIG. 9 is spaced from the insertion hole 112 by a distance g. With the land 117 spaced from the insertion hole 112, the distal end of the filamentary terminal 113a of the electronic component 113 which is bent over floats in spaced relationship to the board 111 and the land 117 over the distance g, and only the tip of the filamentary terminal 113a is soldered to the land 117. This arrangement allows the expansion and contraction board 111 and the filamentary terminal 113a to be absorbed by a change in the curvature of the bent portion of the filamentary terminal 113a.

According to a modification shown in FIG. 10, the distal ends of the pair of the filamentary terminals 113a of the electronic component 113 are bent over outwardly or away from each other at an angle of 45°, for example, with respect to the proximal ends of the filamentary terminals 113a. In addition, not only the land 117 but also the land 118 extend only partly in contact with the peripheral edge of the corresponding insertion holes 112, the lands 117, 118 being square in shape.

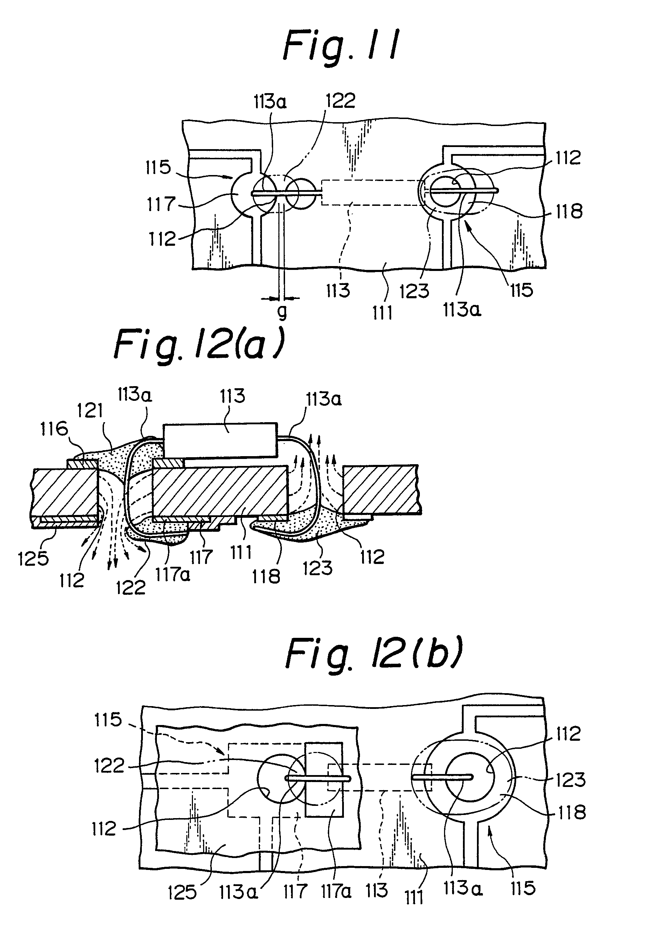

In accordance with a modification of FIG. 11, the distal ends of the filamentary terminals 113a of the electronic component 113 are also bent over outwardly, and the land 117 is of a circular configuration and spaced from the insertion hole 112 by a distance g.

In each of the modified double-sided board circuits shown in FIGS. 8 through 11, the opening of one of the insertion holes 112 at the back of the board 111 is not closed off by a solder body 122, but remains open even when the filamentary terminal 113a is soldered by the solder body 122. A gas produced from the flux when the filamentary terminal 113a is soldered is therefore not trapped in the insertion hole 112 by the solder bodies 121 (see FIGS. 6(a), 6(b), and 7), 122.

FIGS. 12(a) and 12(b) are illustrative of a double-sided board circuit according to a third embodiment of the present invention. The double-sided board circuit of the third embodiment is of the same structure as the doublesided board circuit according to the second embodiment shown in FIGS. 6(a) through 6(c) and 7, except for the details described below, and the filamentary terminals are soldered in the same manner as with the second embodiment. Therefore, the common structure details and soldering process will not be described below in detail. Those parts shown in FIGS. 12(a) and 12(b) which are identical or correspond to those of the double-sided board circuit shown in FIGS. 6(a) through 6(c) and 7 are denoted by identical reference numerals.

As shown in FIGS. 12(a) and 12(b), the land 117 on the back 111b of the board 111, which is one of the lands 116, 117 mounted respectively on the face and back of the board 111 around at least one of the insertion holes 112 and soldered to one of the filamentary terminals 113a of the electronic component 113, is of a rectangular shape disposed fully around the opening of the insertion hole 112. The land 117 is covered with a resist 125, but exposed as a rectangular portion 117a, for example, only at a portion of the peripheral edge of the insertion hole 112. The opening of the insertion hole 112 on the back 111b is not closed off by the solder body 122, but remains open to allow a gas pro duced by the flux when the filamentary terminal 113a is soldered to be discharged out of the insertion hole 112 through the opening thereof.

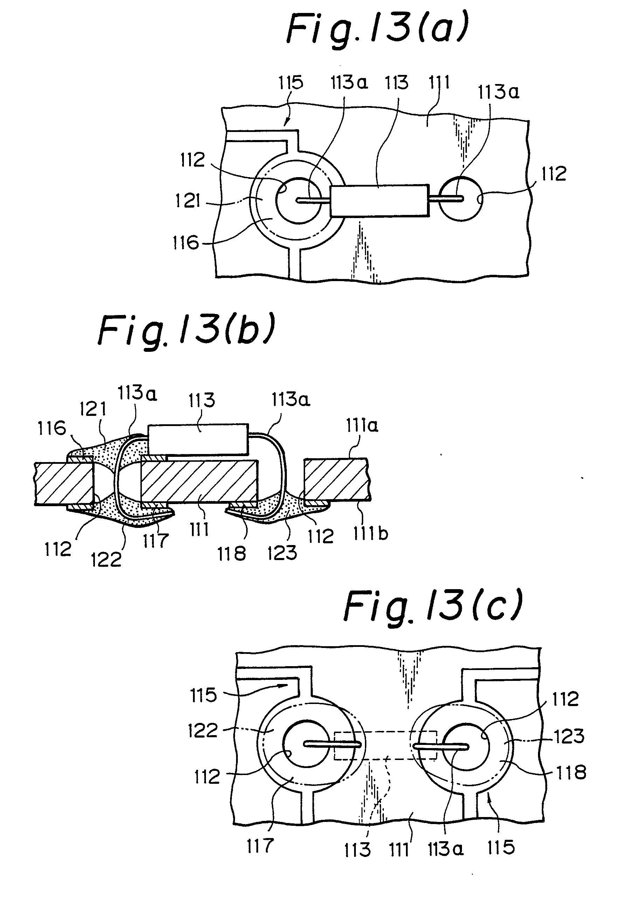

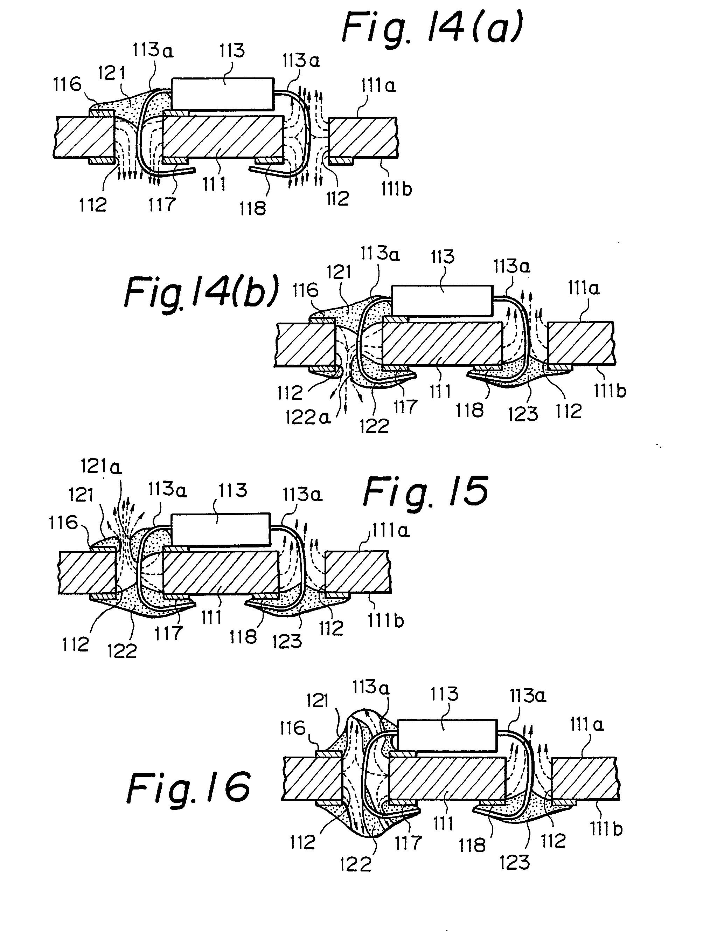

FIGS. 13(a) through 13(c) shows an arrangement different from the present invention, in which the land 117 is not disposed only at a portion of the peripheral edge of the insertion hole 112, but extends fully around the peripheral edge of the insertion hole 112. With such an arrangement, if the filamentary terminal 113a is soldered to the land 116 on the face 111a as shown in FIG. 14(a) and then to the land 117 on the back 111b as shown in FIG. 14(b), a gas produced when the terminal 113a is soldered and trapped in the insertion hole 112 by the solder bodies 121, 122 is forcibly ejected through the solder body 122, thus forming a pinhole 122a through the solder body 122.

As shown in FIG. 15, heat produced when the filamentary terminal 113a is soldered to the land 117 on the back 111b is transmitted through the filamentary terminal 113a to the surface 111a of the board 111. If this happens, the solder body 121 on the surface IIIa may be melted again, forming a pinhole 121a through the solder body 121.

As illustrated in FIG. 16, a gas trapped in the insertion hole 112 tends to force out the solder bodies 121, 122 on the face and back of the board 111, with the result that blowholes are formed through the solder bodies 121, 122 by the ejecting gas.

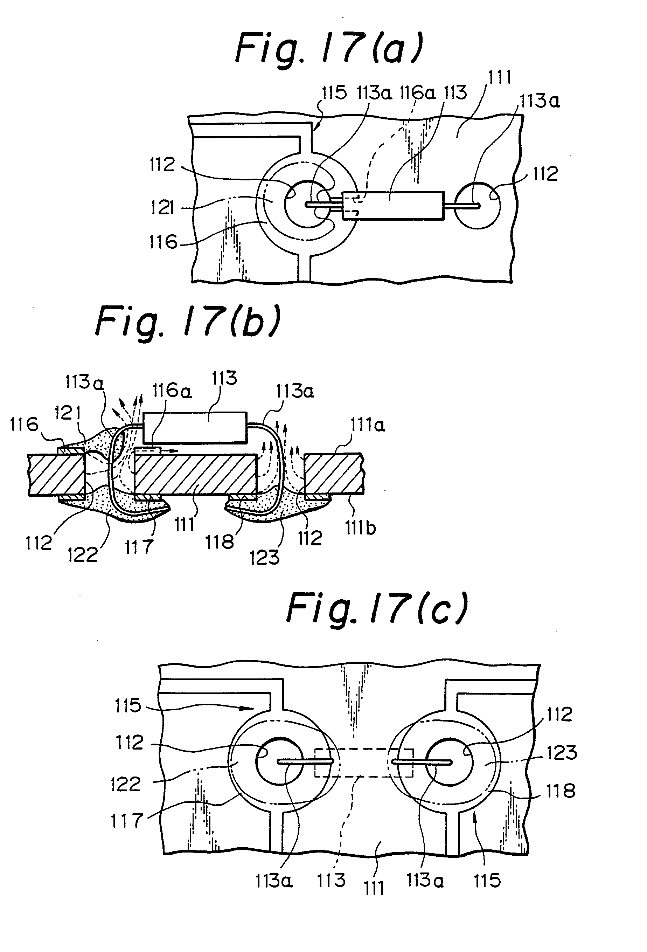

FIGS. 17(a) through 17(c) fragmentarily show a double-sided board circuit according to a fourth embodiment of the present invention. The double-sided board circuit of the fourth embodiment is of the same structure as the double-sided board circuits shown in FIGS. 6(a) through 12, except for the details described below, and those parts shown in FIGS. 17(a) through 17(c) which are identical or correspond to those of the double-sided board circuits shown in FIGS. 6(a) through 12 are denoted by identical reference numerals. With the double-sided board circuits shown in FIGS. 6a through 12, the filamentary terminals are first soldered to the lands on the face 111a of the board 111, and thereafter soldered to the lands on the back 111b. According to the fourth embodiment, the soldering procedure is reversed, i.e., the filamentary terminals are first soldered to the lands on the back 111b of the board 111, and then soldered to the lands on the face 111a. Since the soldering process itself is however the same as the soldering process effected on the double-sided board circuits shown in FIGS. 6(a) through 7, it will not be described in detail.

As shown in FIGS. 17(a) through 17(c), the land 116 cn the face 111a of the board 111, which is one of the lands 116, 117 mounted respectively on the face and back of the board 111 around at least one of the insertion holes 112 and soldered to one of the filamentary terminals 113a of the electronic component 113, is of a circular shape having a radial straight slit 116a extending parallel to the filamentary terminal 113a. Therefore, the land 116 is not of a fully annular shape extending all the way around the opening of the insertion hole 112, but extends only at a portion of the peripheral edge of the insertion hole 112. The land 117 on the back 111b of the board 111 is of a completely annular configuration extending fully around the peripheral edge of the insertion hole 112. Inasmuch as the land 116 has the radial slit 116a, the opening of the insertion hole 112 at the surface 111a is not closed off by the solder body 121, but remains open to allow a gas produced from the flux when the filamentary terminal 113a is soldered to be discharged out of the insertion hole 112 through the opening thereof.

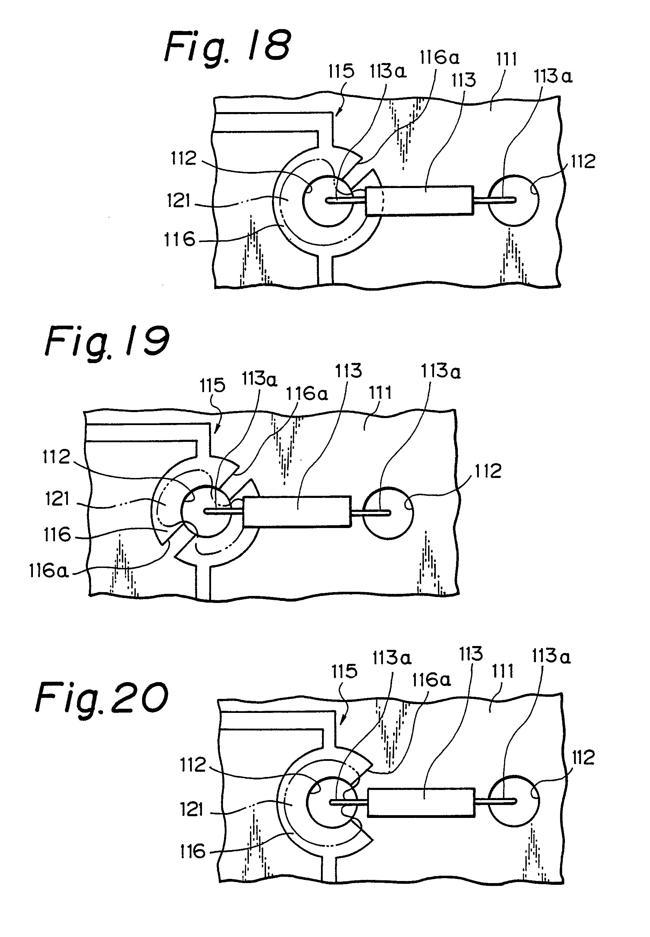

While the slit 116a in the land 116 extends parallel to the filamentary terminal 113a in FIGS. 17(a) through 17(c), the slit 116a may be inclined with respect to the filamentary terminal 113a according to a modification shown in FIG. 18. Alternatively, a plurality of slits 116a may be defined in the land 116 for efficiently discharging a produced gas according to another modification illustrated in FIG. 19. The slit 116a or each of the slits 116a is not limited to a straight configuration, but may be of any of various shapes such as a sectorial shape as shown in FIG. 20.

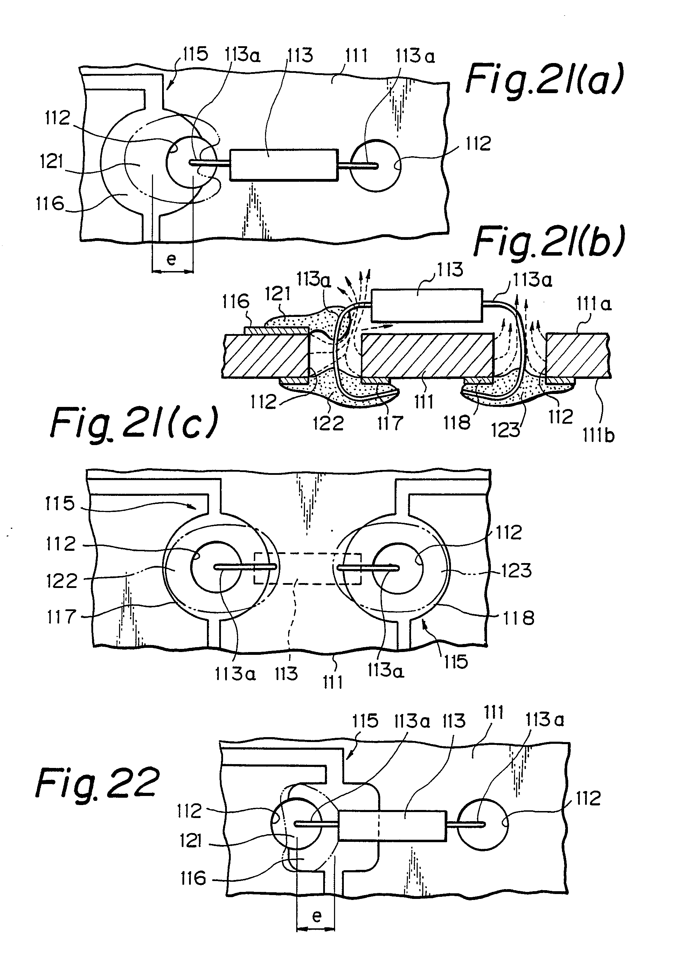

FIGS. 21(a) through 21(c) fragmentarily show a double-sided board circuit according to a fifth embodiment of the present invention.

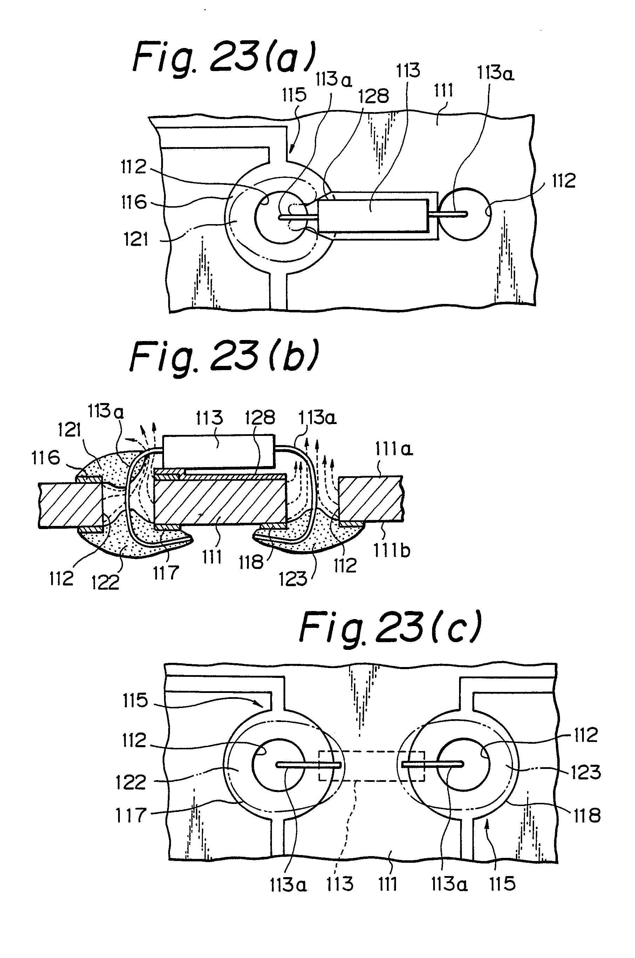

As shown in FIGS. 23(a) through 23(c), the land 116 on the face 111a of the board 111, which is one of the lands 116, 117 mounted respectively on the face and back of the board 111 around at least one of the insertion holes 112 and soldered to one of the filamentary terminals 113a of the electronic component 113, is of a circular shape having its center displaced by a distance e from the center of the insertion hole 112 and an outer peripheral edge crossing the peripheral edge of the insertion hole 112. Therefore, the land 116 does not completely surround the insertion hole 112, but extends only at a portion of the peripheral edge of the insertion hole 112. The land 117 on the back 111b of the board 111 is of an annular configuration extending fully around the peripheral edge of the insertion hole 112. The opening of the insertion hole 112 at the surface 111a is not closed off by the solder body 121, but remains open to prevent a gas produced from the flux when the filamentary terminal 113a is soldered from being trapped in the insertion hole 112 by the solder bodies 121, 122. Therefore, pinholes and blowholes as shown in FIGS. 14 through 16 are not formed through the fused solder bodies 121, 122.

Although the land 116 shown in FIGS. 21(a) and 21(b) is circular in shape, it may be of a substantially rectangular shape as shown in FIG. 22.

FIGS. 23(a) through 23(c) fragmentarily illustrate a double-sided board circuit according to a sixth embodiment of the present invention.

As shown in FIGS. 23(a) through 23(c), the land 116 on the face 111a of the board 111, which is one of the lands 116, 117 mounted respectively on the face and back of the board 111 around at least one of the insertion holes 112 and soldered to one of the filamentary terminals 113a of the electronic component 113, is of an annular shape extending fully around the opening of the insertion hole 112. The land 116 is partly covered in a sectorial shape with one end of a resist 128 extending as a web between the insertion hole 112 and an adjacent insertion hole 112. The land 117 on the back 111b of the board 111 is also of an annular configuration extending fully around the peripheral edge of the insertion hole 112, but is not covered with a resist. The opening of the insertion hole 112 at the surface 111a is not closed off by the solder body 121, but remains open even when the filamentary terminal 113a is soldered. A gas produced from the flux when the filamentary terminal 113a is soldered is thus not trapped in the insertion hole 112 by the solder bodies 121, 122.

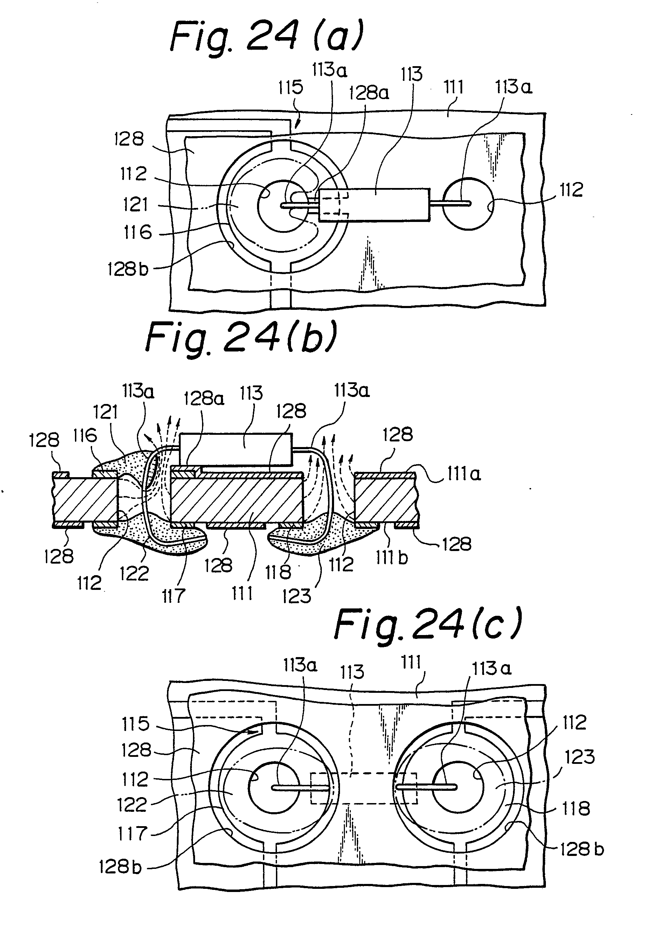

FIGS. 24(a) through 24(c) and 25 through 29 show various modifications of the double-sided board circuit illustrated in FIGS. 23(a) through 23-(c).

In the double-sided board circuit shown in FIGS. 23(a) through 23(c), the resist 128 extends as a web between the two adjacent insertion holes 112. According to a modified double-sided board circuit shown in FIGS. 24(a) through 24(c), however, resists 128 are disposed respectively on the face and back of the board 111 in covering relation to the substantially entire surfaces of the conductive patterns 115. The resists 128 do not however cover the annular lands 116 through 118 disposed near the insertion holes 112, except that the land 116 on the face 111a is partly covered with a web-shaped resist 128a extending radially of the land 116 parallel to the filamentary terminal 113a of the electronic component 113. Therefore, the land 116 is exposed not fully around the peripheral edge of the insertion hole 112 surrounded by the land 116. The opening of this insertion hole 112 at the surface 111a is thus not closed off by the solder body 121.

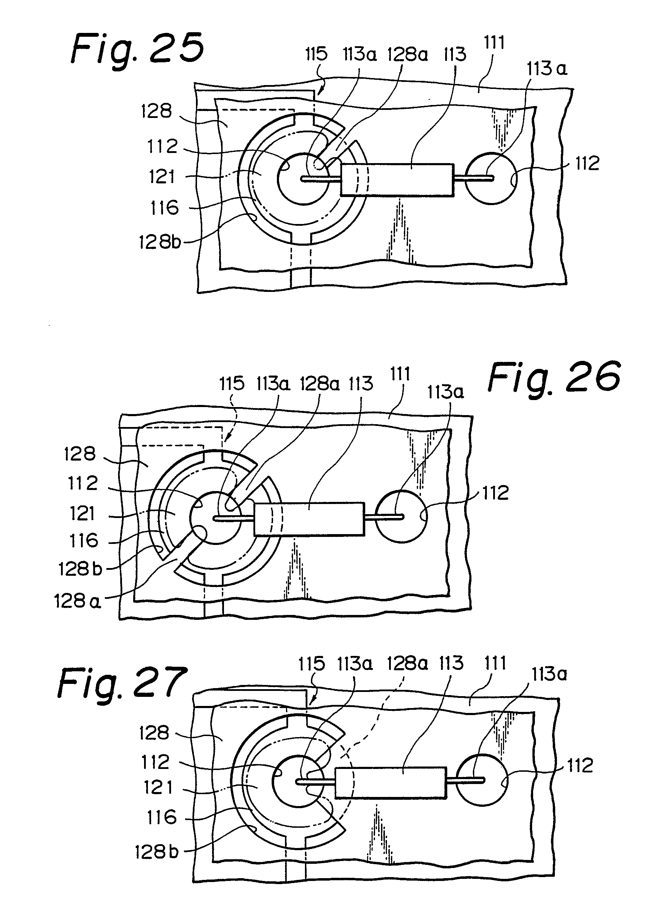

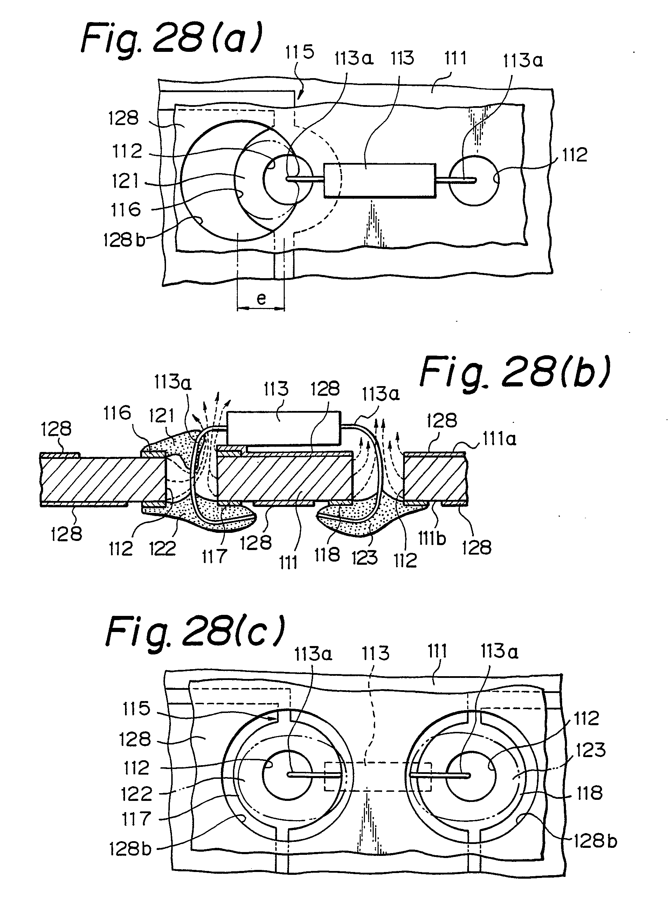

While the resist 128a covering a portion of the annular land 116 extends parallel to the filamentary terminal 113a of the electronic component 113 in the modification shown in FIGS. 24(a) through 24-(c), the resist 128a may be inclined with respect to the filamentary terminal 113a according to a modification shown in FIG. 25. Alternatively, a plurality of resists 128a may be defined in the land 116 for efficiently discharging a produced gas according to another modification illustrated in FIG. 26. The resist 128a or each of the resists 128a is not limited to a straight configuration, but may be of any of various shapes such as a sectorial shape as shown in FIG. 27.

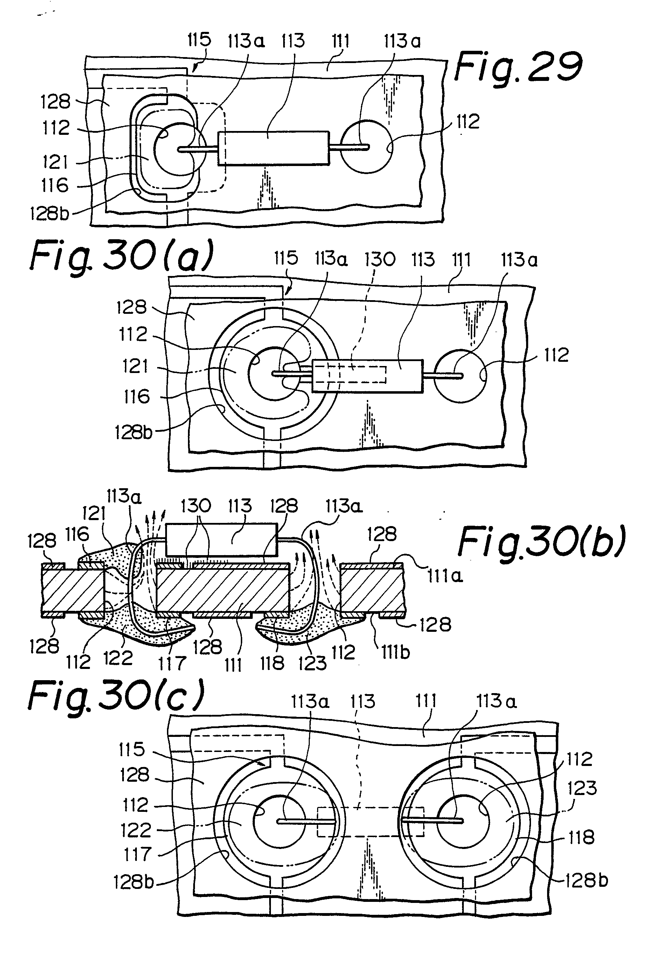

A modified double-sided board circuit shown in FIGS. 28(a) through 28(c) will be described below. In the modification of FIGS. 24(a) through 24(c), the resists 128 have circular openings 128b defined concentrically with the lands 116 through 118 in order to expose these lands. According to the modification shown in .FIGS. 28(a) through 28(c), the circular opening 128b defined in the resist 128 and associated with the land 116 on the face 111a of the board 111, which is one of the lands 116, 117 mounted respectively on the face and back of the board 111, has its center displaced by a distance e from the center of the land 116. Therefore, the peripheral edge of the opening 128b crosses the peripheral edges of the land 116 and the insertion hole 112. Thus, the land 116 is exposed not fully around the peripheral edge of the insertion hole 112. With this configuration, the opening of the insertion hole 112 is not fully closed off by the solder body 121, but remains open at all times. Although in the modification of FIGS. 28(a) through 28(c) the land 116 and the opening 128b of the resist 128 associated therewith are circular in shape, the land 116 and the opening 128b may be rectangular in shape as shown in FIG. 29.

FIGS. 30(a) through 30(c) fragmentarily show a double-sided board circuit according to a seventh embodiment of the present invention.

As shown in FIGS. 30(a) through 30(c), resists 128 are disposed respectively on the face and back of the board 111 in covering relation to the substantially entire sur faces of the conductive patterns 115 on the face and back of the board 111. The resists 128 have circular openings 128b defined therein concentrically with the annular lands 116 through 118 and having a larger diameter than these lands, thus leaving the lands 116 through 118 uncovered or exposed. However, the land 116 on the face 111a is partly covered with a sectorial silk resist 130 extending radially of the land 116 parallel to the filamentary terminal 113a of the electronic component 113. Therefore, the land 116 is exposed not fully around the peripheral edge of the insertion hole 112 surrounded by the land 116. The opening of this insertion hole 112 at the surface 111a is thus not fully closed off by the solder body 121. After the filamentary terminal 113a is soldered, the opening of the insertion hole 112 at the face 111a remains open at all times, so that a gas produced from the flux when the terminal 113a is soldered will not be trapped in the insertion hole 112 by the solder bodies 121, 122.

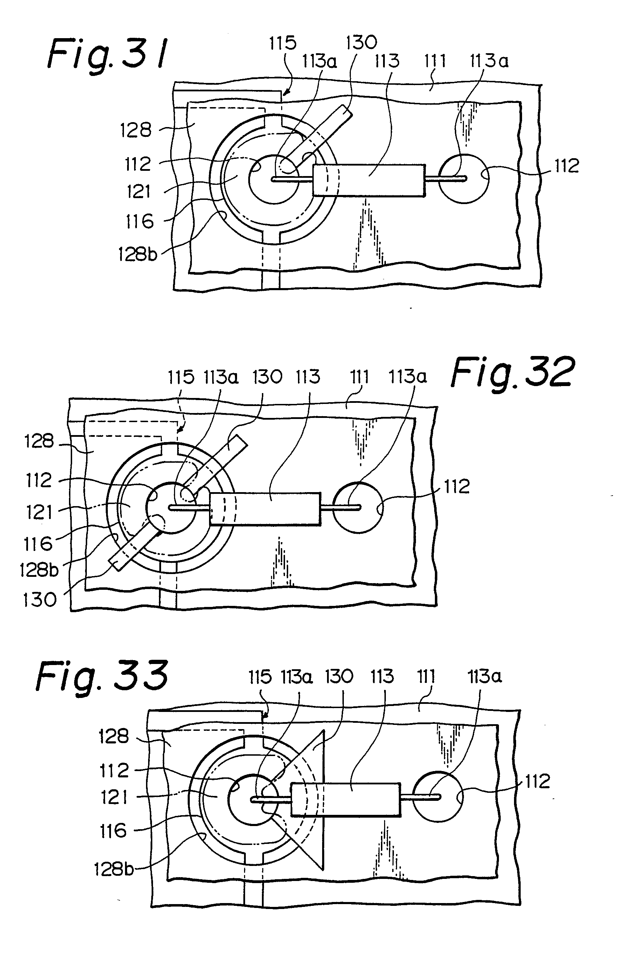

While the silk resist 130 covering a portion of the annular land 116 extends parallel to the filamentary terminal 113a of the electronic component 113 in the double-sided board circuit shown in FIGS. 30(a) through 30(c), the silk resist 130 may be inclined with respect to the filamentary terminal 113a according to a modification shown in FIG. 31. Alternatively, a plurality of silk resists 130 may be disposed on the land 116 for efficiently discharging a produced gas according to another modification illustrated in FIG. 32. The silk resist 130 or each of the silk resists 130 is not limited to a web shape, but may be of any of various shapes such as a sectorial shape as shown in FIG. 33.

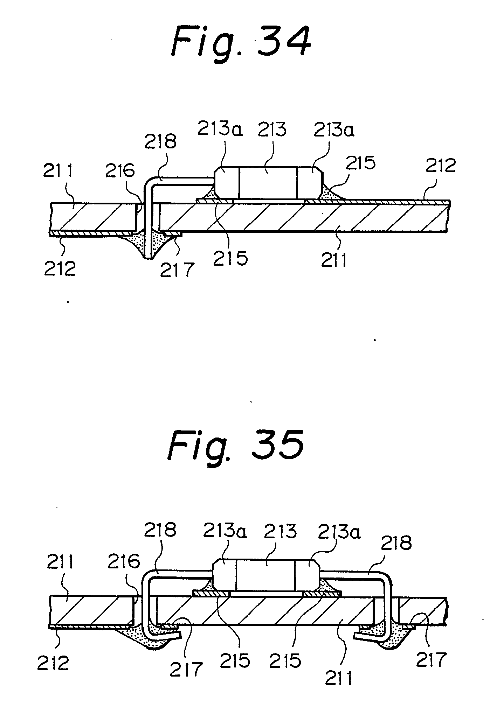

FIGS. 34 and 35 show a double-sided board circuit according to an eighth embodiment of the present invention. As shown in FIGS. 34 and 35, the double-sided board circuit includes electrically conductive patterns 212 disposed on the face and back of a board 211 on which there are disposed mounting lands 215 soldered to conductive ends 213a serving as input and output terminals of a surface-mounted component 213 referred to as a chip. The board 211 has through holes 216 defined therein and extending between the face and back thereof, the holes 216 being positioned near the mounting lands 215. Short-circuiting lands 217 are disposed around the peripheral edges of the through holes 216 on the back of the board 211.

Electrically conductive wires 218 are welded or fused to the conductive ends 213a serving as the input- and output terminals of the surface-mounted component 213. The conductive wires 218 are inserted into the through holes 216, respectively, at the same time that the surface-mounted component 213 is placed on the mounting lands 215.

The conductive wires 218 inserted through the holes 216 are then soldered to the short-circuiting lands 217 disposed around the peripheral edges of the through holes 216. The conductive ends 213a of the surface-mounted component 213 are soldered to the mounting lands 215.

Therefore, the conductive patterns 212 on the face and back of the board 211 are electrically connected to each other through the conductive wires 218 and the conductive ends 213a of the surface-mounted component 213.

With a double-sided board circuit according to the present invention, as described above, the board with the conductive patterns mounted on the face and back thereof has through holes in which the filamentary terminals of an electronic component are inserted, and the lands are formed around the peripheral edges of the through holes on the face and back of the board, at least one of the filamentary terminals inserted through the insertion holes being soldered to the lands on both the face and back of the board. Therefore, the conductive patterns on the face and back of the board are electrically connected to each other, and it is no longer necessary to define through holes in the board, deposit plated metal layers in the through holes, or to use jumper wires, just for connecting the conductive patterns, as is the case with the conventional double-sided board circuits. The efficiency of utilization of the surface area of the board is increased, the cost of the double-sided board circuit is lowered, and the efficiency of assembling the double-sided board circuit is increased. Since at least one of the filamentary terminals is soldered to the lands on the face and back of the board, a load imposed on the filamentary terminal can be divided into a tensile load and a compressive load, making the connection between the conductive patterns strong enough to prevent the conductive patterns from being peeled or separated from the board.

According to another double-sided board circuit of the invention, at least one of the lands mounted respectively on the face and back of the board and soldered to the filamentary terminal in a through hole extends only at a portion of the peripheral edge of the through hole, leaving the through hole open without being closed off the solder bodies.

A gas produced from the flux when the filamentary terminal is soldered is not trapped in the through hole, and hence no pinhole or blowhole is prevented from being formed in the fused solder bodies. The efficiency of assembling the double-sided board circuit is further increased, and a high yield of double-sided board circuits is obtained.

In still another double-sided board circuit according to the present invention, mounting lands are disposed on the face or back of the board having electrically conductive patterns on its opposite surfaces, and electrically conductive ends of a surface-mounted component are soldered to the mounting lands. The board has through holes defined therethrough between the face and back thereof and positioned near the mounting lands, and short-circuiting lands are disposed on the surface of the board on which the surface-mounted component is mounted and the opposite surface of the board, and extends around the peripheral edges of the through holes. Electrically conductive wires are connected respective to the conductive ends of the surface-mounted component. At the same time that the surface-mounted component is placed on the mounting lands, the conductive wires are inserted through the through holes, and then the conductive ends of the surface-mounted components are soldered to the mounting lands and the conductive wires are soldered to the soldering lands. With this arrangement, conductive patterns on the face and back of the board can be electrically connected by the conductive wires which have been inserted at the same time that the component has been mounted. It is not necessary to define through holes in the board and deposit plated metal layers in the through holes in the board, or to define through holes in the board and insert jumper wires through the holes in addition to the insertion of the terminals of an electronic component through the board, as was the case with the conventional double-sided board circuits. Therefore, the efficiency of utilization of the surface area of the board is increased, the cost of the double-sided board circuit is lowered, and the efficiency of assembling the double-sided board circuit is increased.

Although certain preferred embodiments have been shown and described, it should be understood that many changes and modifications may be made therein without departing from the scope of the appended claims.

## Claims

1. A double-sided board circuit comprising:
a board having insertion holes;
a pair of electrically conductive patterns disposed on the face and back of said board; and
an electronic component having directly connected electrically conductive wires inserted respectively through said insertion holes, at least one of said conductive wires being soldered at two positions to said conductive patterns on the face and back of said board.

2. A double-sided board circuit comprising:
a board having groups of insertion holes;
a pair of electrically conductive patterns disposed on the face and back of said board and including lands disposed around peripheral edges of said insertion holes; and
components having filamentary terminals inserted through said groups of insertion holes and soldered to said lands;
the lands disposed around at least one of said insertion holes being disposed respectively on the face and back of said board, the other lands being disposed. on at least one of the face and back of said board, the filamentary terminal which is inserted through said one of the insertion holes being soldered to the lands on the face and back of the board.

3. A double-sided board circuit comprising:
a board having groups of insertion holes;
a pair of electrically conductive patterns disposed on the face and back of said board and including lands disposed around peripheral edges of said insertion holes; and
components having filamentary terminals inserted through said groups of insertion holes and soldered to said lands;
the lands disposed around at least one of said insertion holes being disposed respectively on the face and back of said board, the filamentary terminal which is inserted through said one of the insertion holes being soldered to the lands on the face and back of the board, at least one of said lands disposed around said one of the insertion holes on the face and back of the board extending only at a portion of the peripheral edge of said one of the insertion holes.

4. A double-sided board circuit according to claim 3, wherein said at least one of the lands is spaced from said one of the insertion holes.

5. A double-sided board circuit according to claim 3, further including a resist covering said at least one of the lands disposed around said one of the insertion holes while leaving said at least one of the lands exposed only at a portion of the peripheral edge of said one of the insertion holes.

6. A double-sided board circuit according to claim 5, wherein said at least one of the lands has an exposed portion spaced from said one of the insertion holes.

7. A double-sided board circuit comprising:
a board;
a pair of electrically conductive patterns disposed on the face and back of said board, at least one of said conductive patterns including mounting lands, the other conductive pattern including short-circuiting lands;
a surface-mounted component having electrically conductive ends soldered to said mounting lands;
said board having through holes defined therein and extending between the face and back of the board, said through holes being free of plated layers; and
electrically conductive wires inserted through said through holes and having ends soldered to said short-circuiting lands and opposite ends connected to said conductive ends, respectively.

*Fig. 1*

*Fig. 2*

*Fig. 3*

*Fig. 4*

Fig.5(a)

Fig.5(b)

Fig.5(c)

Fig.5(d)

Fig.5(e)

Fig.5(f)

# Fig. 6(a)

# Fig. 6(b)

# Fig. 6(c)

Fig. 7

Fig. 8

Fig. 9

Fig.10

# Fig. 11

# Fig. 12(a)

# Fig. 12(b)

## Fig.13(a)

115  113a  113  111  113a

112

121

116

112

## Fig.13(b)

121  113a  113  113a

116  111a

112  122  117  111  118  123  112  111b

## Fig.13(c)

115

122

112

112

123

118

117  113  111  113a  115

*Fig. 14(a)*

*Fig. 14(b)*

*Fig. 15*

*Fig. 16*

EP 0 341 458 A1

## Fig. 17(a)

## Fig. 17(b)

## Fig. 17(c)

# Fig. 18

# Fig. 19

# Fig. 20

Fig.2l(a)

Fig.2l(b)

Fig.2l(c)

Fig.22

Fig. 23(a)

Fig. 23(b)

Fig. 23(c)

Fig. 24 (a)

Fig. 24 (b)

Fig. 24 (c)

Fig. 25

Fig. 26

Fig. 27

*Fig. 28(a)*

*Fig. 28(b)*

*Fig. 28(c)*

*Fig.29*

*Fig.30(a)*

*Fig.30(b)*

*Fig.30(c)*

*Fig.31*

*Fig.32*

*Fig.33*

# Fig. 34

# Fig. 35

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | DE-A-3 521 752 (R. BOSCH GmbH) <br> * Page 4, paragraph 2 - page 5; figure 1 * <br> --- | 1,7 | H 05 K 1/18 <br> H 05 K 3/34 |
| X | ELEKTOR, no. 9, September 1984, pages 62-63, Amsterdam, NL; "Double-sided printed circuit boards" <br> * Figure 1 * <br> --- | 1,2 | |
| X | ELECTRICAL DESIGN NEWS, vol. 13, no. 10, 16th September 1968, pages 42-43, Denver, US; T.B. STEPHENSON: "Good PC-board lead design eliminates solder cracks" <br> * Figure 7 * <br> ----- | 1 | |
| | | | **TECHNICAL FIELDS SEARCHED (Int. Cl.4)** <br><br> H 05 K <br> H 01 R |

The present search report has been drawn up for all claims

| Place of search | Date of completion of the search | Examiner |
|---|---|---|
| THE HAGUE | 11-08-1989 | MES L.A. |